# EUROPEAN PATENT APPLICATION

(11) **EP 2 618 432 A1**
(43) Date of publication of application: **24.07.2013**
(21) Application number: 11824644.6
(22) Date of filing: 30.08.2011
(51) Int. Cl.: H01R 13/703, H01M 8/04

(54) **DC CONNECTION DEVICE**

(30) Priority: 15.09.2010 JP 2010207251
(71) Applicant: Panasonic Corporation, Osaka 571-8501 (JP)
(72) Inventor: KAGAWA, Takuya, Osaka 540-6207 (JP); Tamura, Hideki, Osaka 540-6207 (JP)
(74) Representative: Appelt, Christian W.
(86) International application number: PCT/IB2011/001983
(87) International publication number: WO 2012/035387

(57) **Abstract**

Provided is a DC connection device including a first connector connected to a DC power source side or a load side; and a second connector connected to the first connector. The first connector or the second connector has a semiconductor switch that is turned on when a portion of at least one of terminals of one of the first and second connectors is brought into contact with a terminal of the other of the first and second connectors, and is turned off before the terminal of the one of the first and second connectors is completely separated from the terminal of the other of the first and second connectors.

## Description

### Field of the Invention

The present invention relates to a DC connection device suitable for DC power distribution systems such as a solar photovoltaic power generator or a household fuel cell.

### Background of the Invention

Recently, DC power distribution systems such as a solar photovoltaic power generator and a household fuel cell have been used in common households. The power voltage of these DC power distribution systems is 400 V or so, which is higher than 100 V or 200 V that is the power voltage of conventional DC power distribution systems. As known in the art, if the voltage of a power source increases, an electric arc is generated when a connection device such as a connector or an outlet is connected or disconnected. Particularly, if, in case of DC power, an electric arc is generated when a connection device is disconnected, current is not easily cut off, and continuously flows through a load. Hence, there is a problem of safety. Here, there has been proposed a DC connection device having a capacitor connected between terminals of a plug for DC connection to prevent an electric arc from being generated when the plug is pulled out of an outlet, as described in Japanese Patent Application Publication No. 2009-146783. According to this DC connection device, when the plug is pulled out of the outlet, an electric charge charged in the capacitor is discharged, and the voltage across the terminals of the plug is almost equalized to the voltage across the terminals of the outlet by the discharged current, thereby preventing the generation of an electric arc.

Since the DC connection device has a simple structure, it is possible to provide a small and low-priced DC connection device. However, since the capacitor is provided only at the plug in a load side, it is not possible to prevent an electric arc from being generated when the plug is inserted into the outlet.

### Summary of the Invention

In view of the above, the present invention provides a DC connection device capable of preventing an electric arc from being generated when a plug is inserted into and removed from an outlet.

In accordance with an aspect of the invention, there is provided a DC connection device including a first connector connected to a DC power source or a load; and a second connector connected to the first connector, wherein the first connector or the second connector has a semiconductor switch that is turned on when a portion of at least one of terminals of one of the first and second connectors is brought into contact with a terminal of the other of the first and second connectors, and is turned off before the terminal of the one of the first and second connectors is completely separated from the terminal of the other of the first and second connectors.

In accordance with another aspect of the invention, there is provided a DC connection device including a first connector connected to a DC power source or a load, the first connector having a pair of first connection terminals; and a second connector connected to the first connector, the second connector having a pair of second connection terminals to be electrically connected to the first connection terminals, wherein the first connector includes a semiconductor switch connected in series between the DC power source or the load and any one of the first connection terminals; a connection-state detecting unit for detecting a relative positional relationship between the second connection terminal and the first connection terminal; and a control circuit for turning on or off the semiconductor switch according to a result detected by the connection-state detecting unit, wherein the connection-state detecting unit detects a change in the relative position of the second connection terminal to the first connection terminal, and wherein the control circuit turns on and off the semiconductor switch when the relative position of the second connection terminal to the first connection terminal ensures that the first connection terminal and the second connection terminal are electrically connected.

In the above configuration, to ensure that the first connection terminal and the second connection terminal are electrically connected preferably means a position where the second connection terminal cannot relatively move any more with respect to the first connection terminal, or in the vicinity just before the position.

Preferably, the control circuit turns off the semiconductor switch while the relative position of the second connection terminal to the first connection terminal is reversely moved to change from a state where an electrical connection between the first connection terminal and the second connection terminal is completed to a state where an electrical disconnection between the first connection terminal and the second connection terminal is completed.

Preferably, the connection-state detecting unit is provided at the position in which the second connection terminal cannot relatively move any more with respect to the first connection terminal or in the vicinity just before the position, and includes a mechanical switch to be brought into contact with the second contacting terminal.

Preferably, the connection-state detecting unit is provided at the position in which the second connection terminal cannot relatively move any more with respect to the first connection terminal or in the vicinity just before the position, and includes an optical sensor having a light emitting and light receiving elements for detecting the existence of the second connection terminal.

Preferably, the connection-state detecting unit includes a sensor or a switch provided in a main body of the first connector to detect that a main body of the second connector comes into contact with the main body of the first connector.

Preferably, the first connector has a current detection circuit for detecting a current flowing through the load, and the control circuit turns off the semiconductor switch when a current value detected by the current detection circuit exceeds a predetermined current threshold value and turns on the semiconductor switch when the current value becomes less than or equal to the current threshold value.

Preferably, the first connector has a voltage detection circuit for detecting a voltage applied to the load, and the control circuit turns off the semiconductor switch when a voltage value detected by the voltage detection circuit exceeds a predetermined voltage threshold value and turns on the semiconductor switch when the voltage value becomes less than or equal to the voltage threshold value.

Preferably, the first connector has a current detection circuit for detecting a current flowing through the load and a voltage detection circuit for detecting a voltage applied to the load. The semiconductor switch has two FETs connected in series so that sources and drains of the two FETs are opposed to each other. The control circuit turns off one of the two FETs when a current value detected by the current detection circuit exceeds a predetermined current threshold value, and turns on the one of the two FETs when the current value becomes less than or equal to the current threshold value. The control circuit turns off the other of the two FETs when a voltage value detected by the voltage detection circuit exceeds a predetermined voltage threshold value, and turns on the other of the two FETs when the voltage value becomes less than or equal to the voltage threshold value.

Preferably, the first connector has a current detection circuit for detecting a current flowing through the load and a voltage detection circuit for detecting a voltage applied to the load. The semiconductor switch is a bidirectional switching element having a lateral transistor structure using a GaN/AlGaN structure. The control circuit turns off the bidirectional switching element when a current value detected by the current detection device exceeds a predetermined current threshold value or when a voltage value detected by the voltage detection circuit exceeds a predetermined voltage threshold value and turns on the bidirectional switching element when the current value becomes less than or equal to the current threshold value or when the voltage value becomes less than or equal to the voltage threshold value.

Preferably, the control circuit has a timer, and the control circuit detects, by using the timer, a time duration during which the current value detected by the current detection circuit exceeds the current threshold value and turns off the semiconductor switch when the time duration exceeds a predetermined time threshold value.

Preferably, the first connector further includes a contact switching device connected in series between the first connection terminals and the semiconductor switch.

Preferably, the control circuit turns on the semiconductor switch after the electrical connection between the first connection terminal and the second connection terminal is completed and the contact switching device is turned on.

Preferably, the control circuit turns off the contact switching device after the semiconductor switch is turned off while the relative position of the second connection terminal to the first connection terminal is reversely moved to change from the state where the electrical connection between the first connection terminal and the second connection terminal is completed to the state where the electrical disconnection between the first connection terminal and the second connection terminal is completed.

Preferably, the movement of the second connection terminal to the first connection terminal includes any one of a liner motion and a rotary motion or both the linear and rotary motions, and the control circuit turns on the contact switching device after the second connection terminal cannot relatively move any more with respect to the first connection terminal.

Preferably, the first connector further includes a fixing mechanism for fixing the state where the second connection terminal cannot relatively move any more with respect to the first connection terminal, and the control circuit turns on and off the contact switching device while the second connection terminal is fixed to the first connection terminal by the fixing mechanism.

Preferably, the first connector further includes a pair of third connection terminals to be connected to an AC power source or the load.

Preferably, the first connector further includes an AC circuit breaker connected in series between the AC power source side and any one of the pair of third connection terminals, an AC grounding current detection circuit for detecting a grounding current flowing in an AC circuit between the AC power source and the load or another load, and a DC grounding current detection circuit for detecting a grounding current flowing in a DC circuit between the DC power source and the load, and the control circuit turns off both the semiconductor switch connected to the DC power source and the AC circuit breaker connected to the AC power source when the grounding current is detected by any one of the DC grounding current detection circuit and the AC grounding current detection circuit.

Preferably, the DC grounding current detection circuit and the AC grounding current detection circuit are at least partially common.

In accordance with the present invention, a semiconductor switch is turned on/off only in a state where a portion of a terminal (first connection terminal) of the first connector is connected with a terminal (second connection terminal) of the second connector. For example, when the second connector (e.g., a plug) is connected to the first connector (e.g., an outlet), the semiconductor switch is not turned on until the terminal of the first connector and the terminal of the second connector are electrically connected to each other, so that no electric arc is generated between the terminal of the first connector and the terminal of the second connector. In addition, when the first connector is removed from the second connector, the semiconductor switch is first turned off, and the terminal of the first connector is then disconnected from the terminal of the second connector, so that no electric arc is generated between the terminal of the first connector and the terminal of the second connector. The contact state between the terminal of the first connector and the terminal of the second connector can be detected, for example, by a sensor provided in the first connector, or the like.

### Brief Description of the Drawings

Fig. 1 is a block diagram showing a general configuration of a DC connection device in accordance with an embodiment of the present invention;
Fig. 2 is a view showing a specific configuration of a connection-state detecting unit in the DC connection device;
Fig. 3 is a view showing another specific configuration of the connection-state detecting unit in the DC connection device;
Fig. 4 is a view showing still another specific configuration of the connection-state detecting unit in the DC connection device;
Fig. 5 is a block diagram showing a configuration of a modification of the DC connection device;
Fig. 6 is a view showing an exemplary circuit configuration of a semiconductor switch using FETs;
Fig. 7 is a view showing an exemplary circuit configuration of a semiconductor switch using a bidirectional switching element having a lateral transistor structure using a GaN/AlGaN structure, instead of two FETs;
Fig. 8 is a plan view showing a configuration of a bidirectional switching element (single gate);
Fig. 9 is an enlarged view of area A in FIG. 8;
Fig. 10 is a sectional view taken along line X-X in FIG. 8;
Fig. 11 is a plan view showing a configuration of a bidirectional switching element (dual gate);
Fig. 12 is a sectional view taken along line XII-XII in FIG. 11;
Fig. 13 is a block diagram showing a configuration of another modification of the DC connection device;
Fig. 14 is a view showing an example of a method of connecting and disconnecting a first connector (plug) to and from a second connector (outlet);
Fig. 15 is a view showing an example of a mechanism for fixing the first connector (plug) to the second connector (outlet);
Fig. 16 is a block diagram showing still another modification of the DC connection device;
Fig. 17 is a block diagram showing still another modification of the DC connection device; and
Fig. 18 is a block diagram showing still another modification of the DC connection device.

### Detailed Description of the Embodiments

Hereinafter, embodiments of the present invention will be described in detail with reference to the accompanying drawings which form a part hereof. Throughout the drawings, like reference numerals are used to designate like or similar parts and redundant descriptions thereof will be omitted.

A DC connection device in accordance with an embodiment of the present invention will be described. The DC connection device includes a first connector connected to a DC power source side or a load side and a second connector connected to the first connector. The first connector has a pair of first connection terminals, and the second connector has a pair of second connection terminals electrically connected to the respective first connection terminals. The shape and the use of the first connector and the second connector are not particularly limited, and the shape and the engagement of the first connection terminal and the second connection terminal are also not limited. For convenience, as described below, a connector which includes a semiconductor switch, a connection-state detecting unit and a control circuit is referred to as the first connector, and a connector includes none of them therewith is referred to as the second connector.

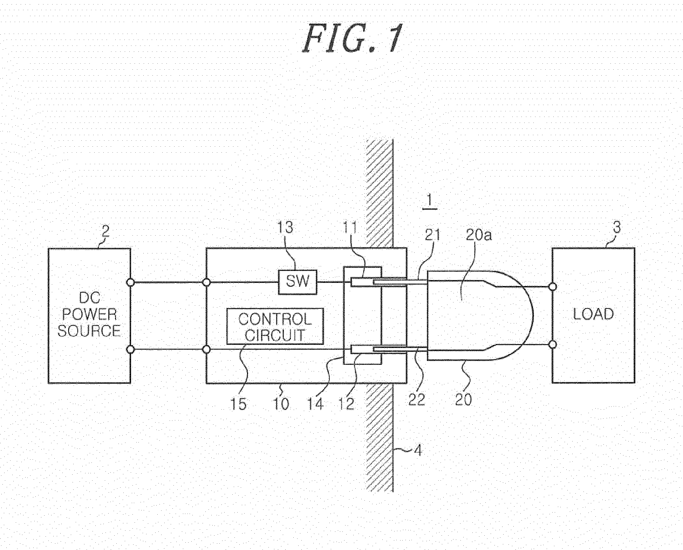

FIG. 1 is a block diagram showing a general configuration of a DC connection device 1 in accordance with an embodiment of the present invention. In FIG. 1, for example, an outlet 10 provided in a wall 4 of a building is illustrated as the first connector, and a plug 20 is illustrated as the second connector. The outlet 10 is connected to a DC power source 2, and the plug 20 is connected to a load 3 driven by DC power, for example, via a cable. The plug 20 has a pair of second connection terminals 21 and 22 protruding from a main body 20a of the plug 20. The outlet 10 has a pair of first connection terminals 11 and 12 electrically connected to the respective second connection terminals 21 and 22 of the plug 20, and a semiconductor switch (SW) 13 connected in series between the DC power source 2 and any one (e.g., the first connection terminal 11) of the pair of first connection terminals 11 and 12. Also, the outlet 10 has a connection-state detecting unit 14 for detecting a relative positional relationship between the second connection terminals 21 and 22 and the first connection terminals 11 and 12, and a control circuit 15 for turning on or off the semiconductor switch according to a result detected by the connection-state detecting unit 14.

The semiconductor switch 13 is, for example, a semiconductor switch element such as a field effect transistor (FET), and the control circuit 15 controls the gate voltage of the FET according to a result detected by the connection-state detecting unit 14. The configuration of the connection-state detecting unit 14 is not particularly limited, but may detect a change in the relative position of the second connection terminals 21 and 22 of the plug 20 with respect to the first connection terminals 11 and 12 of the outlet 10 when the plug 20 is connected to and removed from the outlet 10.

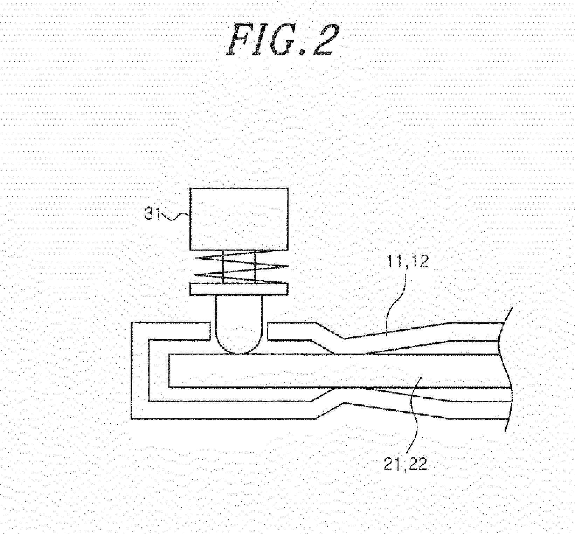

As shown in FIG. 2, the connection-state detecting unit 14 is provided at a position in which the second connection terminals 21 and 22 cannot relatively move any more with respect to the first connection terminal 11 and 12 or in the vicinity just before the position. The connection-state detecting unit 14 may be configured to include a mechanical switch 31 which comes in contact with the second connection terminal 21 or 22.

When the plug 20 is connected to the outlet 10, the second connection terminal 21 or 22 is brought into contact with the mechanical switch 31 at a position where the second connection terminal 21 or 22 cannot relatively move any more with respect to the first connection terminal 11 or 12 or in the vicinity just before the position, so that the mechanical switch 31 is turned on or off. Thus, the control circuit 15 can ensure that the first connection terminal 11 or 12 has been electrically connected to the second connection terminal 21 or 22, whereby the semiconductor switch 13 is turned on.

That is, when the plug 20 is connected to (put into) the outlet 10, a potential difference between the second connection terminal 21 or 22 of the plug 20 and the first connection terminal 11 or 12 of the outlet 10 is small, and therefore, no electric discharge between the first connection terminal 11 or 12 and the second connection terminal 21 or 22 occurs.

Meanwhile, when the plug 20 is removed from (pulled out of) the outlet 10, slight displacement of the second connection terminal 21 or 22 in a reverse direction with respect to the first connection terminal 11 or 12 separates the second connection terminal 21 or 22 from the mechanical switch 31, so that the mechanical switch 31 is turned off or on. In this step, the first connection terminal 11 or 12 remains electrically connected to the second connection terminal 21 or 22. For this reason, the control circuit 15 rapidly turns off the semiconductor switch 13 before the first connection terminal 11 or 12 is completely disconnected from the second connection terminal 21 or 22. That is, when the plug 20 is removed from (pulled out of) the outlet 10, the semiconductor switch 13 is first turned off, and then, the potential of the first connection terminal 11 or 12 becomes equal to that of the second connection terminal 21 or 22. Thus, no electrical discharge occurs between the first connection terminal 11 or 12 and the second connection terminal 21 or 22.

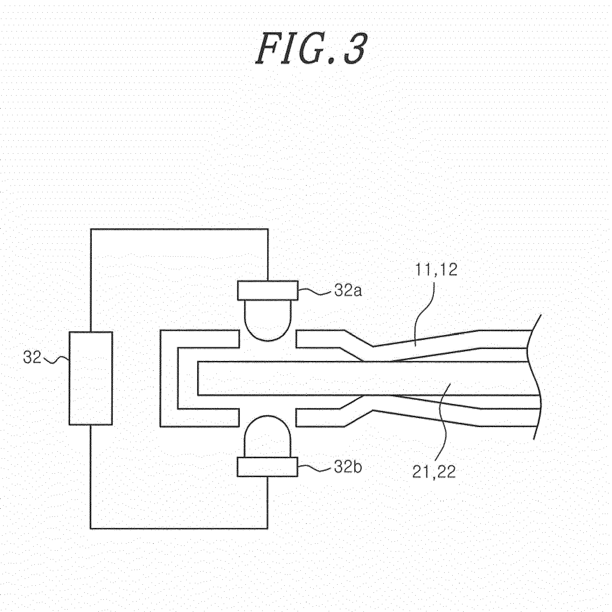

Alternatively, as shown in FIG. 3, the connection-state detecting unit 14 may be configured to include an optical sensor 32 having a light emitting element 32a and a light receiving element 32b, which are provided at substantially the same position as that of the mechanical switch 31. In this case, the second connection terminal 21 or 22 blocks the light emitted from the light emitting element 32a at a position where the second connection terminal 21 or 22 cannot relatively move any more with respect to the first connection terminal 11 or 12 or in the vicinity just before the position. Thus, an output signal of the light receiving element 32b changes from a high level to a low level. Accordingly, the control circuit 15 can ensure that the first connection terminal 11 or 12 has been electrically connected to the second connection terminal 21 or 22, whereby the semiconductor switch 13 is turned on. Meanwhile, in the case where the plug 20 is removed from (pulled out of) the outlet 10, when the second connection terminal 21 or 22 is slightly displaced in a reverse direction with respect to the first connection terminal 11 or 12, the light emitted from the light emitting element 32a enters the light receiving element 32b. Then, the output signal of the light receiving element 32b changes from a low level to a high level, and thus, the control circuit 15 turns off the semiconductor switch 13.

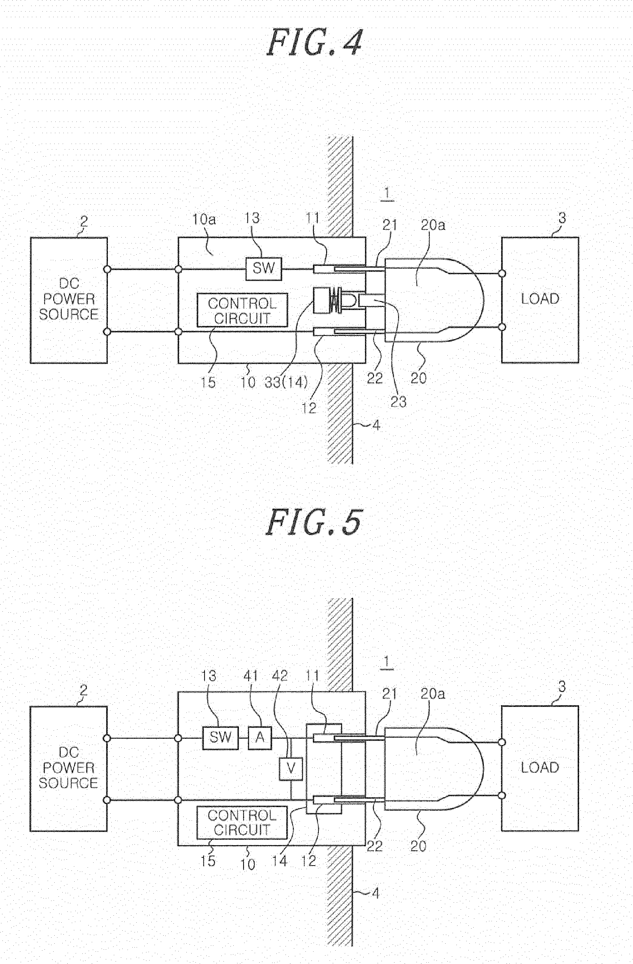

Alternatively, as shown in FIG. 4, the connection-state detecting unit 14 may be configured to include a projection 23 provided on the main body 20a of the plug 20, a push-on switch 33 provided in the outlet 10, and the like. In this case, when the plug 20 is connected to the outlet 10 and the main body 20a of the plug 20 comes into contact with a main body 10a of the outlet 10, the projection 23 turns on the push-on switch 33. Accordingly, the control circuit 15 can ensure that the first connection terminal 11 or 12 has been electrically connected to the second connection terminal 21 or 22, whereby the semiconductor switch 13 is turned on. Note that, without the projection on the main body 20a of the plug 20, the connection-state detecting unit 14 may be configured so that a front end portion of the push-on switch 33 protrudes out of the main body 10a of the outlet 10. However, the connection-state detecting unit 14 is preferably configured as shown in Fig. 4, in consideration of children's mischief. A sensor for detecting whether or not the main body 20a of the plug 20 is in contact with the main body 10a of the outlet 10 may be used instead of the push-on switch 33.

FIG. 5 shows a modification of the DC connection device 1 according to this embodiment. In this modification, the outlet 10 further includes a current detection circuit (A) 41 for detecting current flowing through the load 3 and a voltage detection circuit (V) 42 for detecting voltage applied to the load 3. Further, at least one current threshold value and at least one voltage threshold value are determined in the control circuit 15. When the current value detected by the current detection circuit (A) 41 exceeds the current threshold value, the control circuit 15 controls the semiconductor switch 13 to be turned off. When the current value becomes less than or equal to the current threshold value, the control circuit 15 controls the semiconductor switch 13 to be turned on. Depending on the kind of loads driven by DC power, a transient current (rush current) may flow when the power is supplied. For example, in a case where an FET (field effect transistor) is used as the semiconductor switch 13, this semiconductor switch 13, the current detection circuit (A) 41, and the control circuit 15 may configure a rush current prevention circuit. The control circuit 15 controls a duty ratio of the FET, thereby suppressing the rush current. In addition, when the voltage value detected by the voltage detection circuit (V) 42 exceeds the voltage threshold value, the control circuit 15 controls the semiconductor switch 13 to be turned off. When the voltage value becomes less than or equal to the voltage threshold value, the control circuit 15 controls the semiconductor switch 13 to be turned on. For example, when another load is connected to the DC power source 2 via another outlet or the like to lower the voltage of the power source, or when the DC power source is stopped, the voltage on the load 3 side instantaneously increases, and a reverse current flows from the load 3 side to the DC power source 2 side. In a case where the FET is used as the semiconductor switch 13, this semiconductor switch 13, the voltage detection circuit 42, and the control circuit 15 may configure a reverse current prevention circuit. When a reverse transient voltage is generated, the semiconductor switch 13 is turned off, thereby preventing the reverse current from flowing from the load 3 side to the DC power source 2 side. Both the current detection circuit (A) 41 and the voltage detection circuit (V) 42 need not be provided, but either one of both the circuits may be provided.

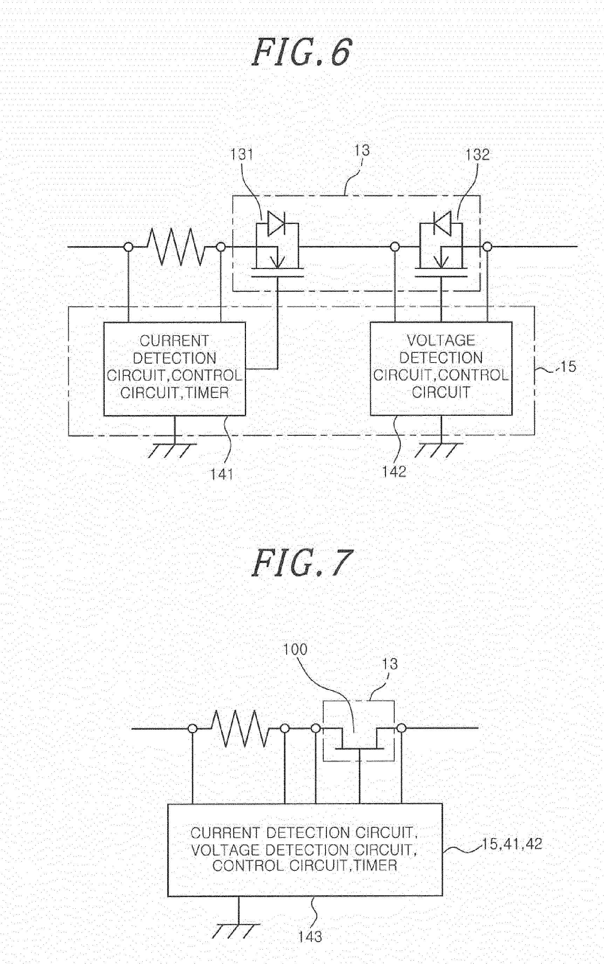

FIG. 6 shows an exemplary circuit configuration using FETs as the semiconductor switch 13. The semiconductor switch 13 is configured to connect, in series, two FETs 131 and 132 whose sources and drains are opposed to each other. The control circuit 15 includes an IC 141 integrally formed with the current detection circuit (A) 41 and a gate control circuit of the FET 131; and an IC 142 integrally formed with the voltage detection circuit (V) 42 and a gate control circuit of the FET 132. As such, the two FETs as the semiconductor switch are reversely connected to each other, and are independently controlled, thereby simultaneously preventing both the transient current (rush current) and the reverse current. In addition, a function of a timer may be further provided in the IC 141, and a time threshold value may be further set therein. The IC 141 (control circuit) detects a time duration during which the current value detected by the current detection circuit (A) 41 exceeds the current threshold value, and turns off the FET 131 when the detected time duration exceeds the time threshold value. Accordingly, the DC power distribution system can be protected from transient current caused by a short circuit of the load, or the like. Similarly, the FET 132 is controlled to be turned off when the voltage value detected by the voltage detection circuit (V) 142 exceeds the voltage threshold value, and the FET 132 is controlled to be turned on when the voltage value becomes less than or equal to the voltage threshold value. By doing so, it is possible to prevent reverse current from flowing from the load 3 side to the DC power source 2 side.

FIG. 7 shows an exemplary circuit configuration using a bidirectional switching element 100 having a lateral transistor structure using a GaN/AlGaN structure instead of the aforementioned two FETs, as the semiconductor switch 13. Since the FET has a diode structure, a current flows when a forward voltage is applied to the diode regardless of a gate voltage. For this reason, as described above, the two FETs should be connected in series so as to apply a reverse voltage to the diode. On the other hand, since the bidirectional switching element has no diode structure, the same function can be performed using only one element. Advantageously, the bidirectional switching element having the lateral transistor structure using the GaN/AlGaN structure has no loss due to the diode structure, whereby its loss is lowered as compared with the FET, and also can integrate the control circuits. That is, the control can be performed using an IC 143 in which the current detection circuit (A) 41, the voltage detection circuit (V) 42, the control circuit 15 and the timer are integrated.

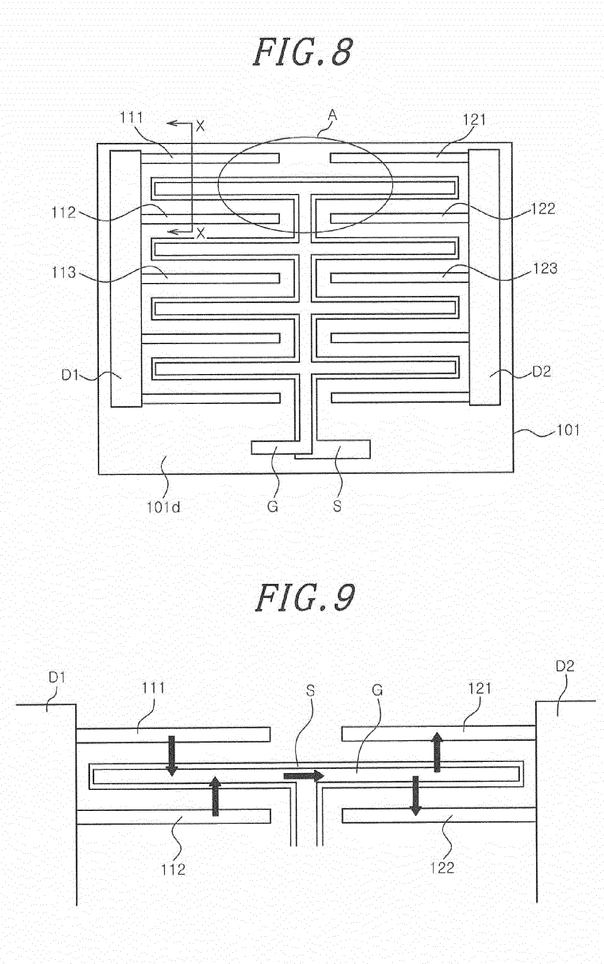

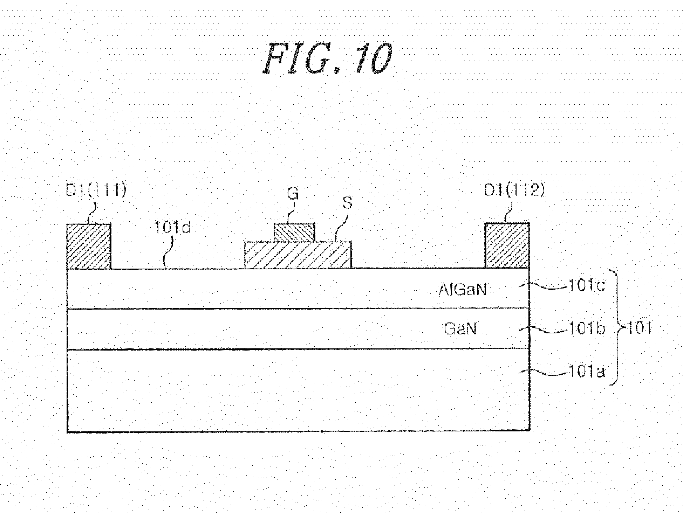

The bidirectional switching element 100 having the lateral transistor structure using the GaN/AlGaN structure will be described in detail with reference to FIGS. 8 to 10. FIG. 8 is a plan view showing the configuration of the bidirectional switching element 100, FIG. 9 is an enlarged view of area A, and FIG. 10 is a sectional view taken along line X-X in FIG. 8. The bidirectional switching element 100 is provided with only one gate G between two electrodes D1 and D2 and is therefore referred to as a single gate type.

As shown in FIG. 10, a substrate 101 of the bidirectional switching element 100 includes a conductor layer 101a, and a GaN layer 101b and an AlGaN layer 101c which are laminated on the conductor layer 101a. In this embodiment, a two-dimensional electron gas layer generated on an AlGaN/GaN heterogeneous interface is used as a channel layer. As shown in FIG. 8, on a surface 101d of the substrate 101, there are formed a first electrode D1 and a second electrode D2 respectively connected in series to the DC power source 2 and the load 3; and an intermediate potential portion S that has an intermediate potential between a potential of the first electrode D1 and a potential of the second electrode D2. In addition, a control electrode (gate) G is formed on the intermediate potential portion S. For example, a schottky electrode is used as the control electrode G. The first electrode D1 and the second electrode D2 are formed in comb shapes having electrode portions 111, 112, 113, ... and electrode portions 121, 122, 123, ... arranged in parallel with one another, respectively. The comb-shaped electrode portions of the first electrode D1 are arranged opposite to those of the second electrode. The intermediate potential portion S and the control electrode G are arranged between the comb-shaped electrode portions 111, 112, 113, ... and 121, 122, 123, ..., to have a shape (a shape of a backbone of a fish) similar to the planer shape of a space defined between the electrode portions.

Next, the lateral transistor structure of the bidirectional switching element 100 will be described. As shown in FIG. 9, the electrode portion 111 of the first electrode D1 and the electrode portion 121 of the second electrode D2 are arranged so that the center lines of the electrode portions in the widthwise direction are aligned. The intermediate potential portion S and the control electrode G are provided in parallel with the electrode portion 111 of the first electrode D1 and the electrode portion 121 of the second electrode D2. The distances from the electrode portion 111 of the first electrode D1 and the electrode portion 121 of the second electrode D2 to the intermediate potential portion S and the control electrode G are set so that a predetermined withstand voltage can be maintained. The distances in the longitudinal direction of the electrode portion 111 of the first electrode D1 and the electrode portion 121 of the second electrode D2, i.e., perpendicular to the widthwise direction are also set in the same manner.

In addition, such a relationship is similarly applied to the other electrode portions 112, 113, ... and 122, 123, .... That is, the intermediate potential portion S and the control electrode G are arranged at a position where the predetermined withstand voltage can be maintained with respect to the first electrode D1 and the second electrode D2.

For this reason, assuming that the first electrode D1 is in a high potential side and the second electrode D2 is in a low potential side, when the bidirectional switching element 100 is turned off, a current is completely interrupted between at least the first electrode D1, the control electrode G and the intermediate potential portion S(the current is blocked immediately below the control electrode (gate) G).

Meanwhile, when the bidirectional switching element 100 is turned on, i.e., when a signal having a voltage of a predetermined threshold value or more is applied to the control electrode G, a current flows along the path of the first electrode D1 (electrode portions 111, ...), the intermediate potential portion S and the second electrode D2 (electrode portions 121, ...) as shown by arrows in FIG. 9, and vice versa. As a result, even if the threshold voltage of the signal applied to the control electrode G is lowered to a desired minimum level, the bidirectional switching element 100 can be surely turned on/off, thereby enabling a low on-resistance. Further, since the electrode portions 111, 112, 113, ... of the first electrode D1 and the electrode portions 121, 122, 123, ... of the second electrode D2 can be arranged in a comb shape, high current can be obtained without enlarging a chip size of the bidirectional switching element 100.

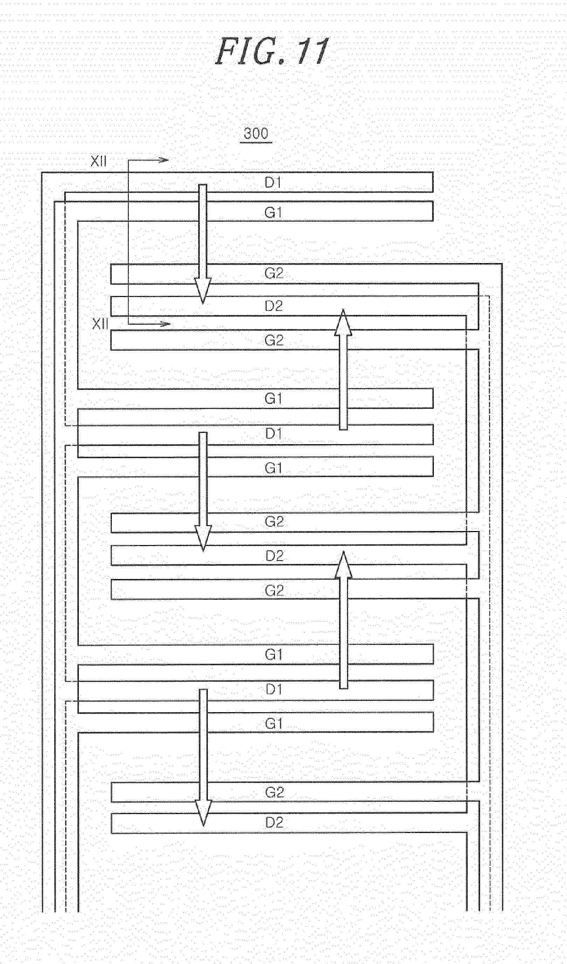

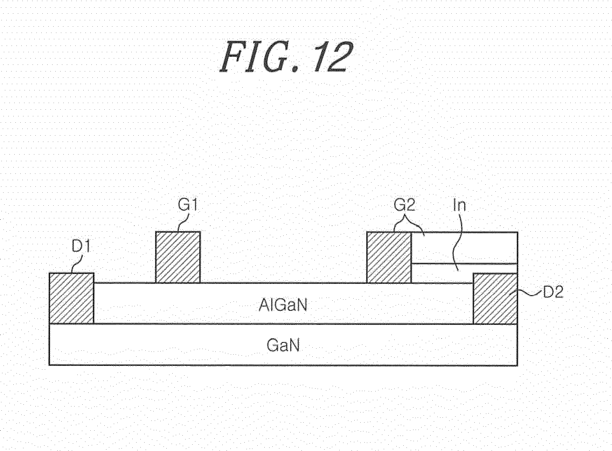

FIGS. 11 and 12 show a configuration of another bidirectional switching element 300 having a lateral transistor structure using the GaN/AlGaN structure. FIG. 11 is a plan view showing the configuration of the bidirectional switching element 300, and FIG. 12 is a sectional view taken along line XII-XII in FIG. 11. The bidirectional switching element 300 is provided with two gates G1 and G2 between two electrodes D1 and D2, and therefore, is referred to as a dual gate transistor.

As shown in FIGS. 11 and 12, the bidirectional switching element 300 having the dual gate transistor structure is configured to have a single portion for maintaining a withstand voltage, so that it is possible to implement a bidirectional element with a small loss. That is, each of the drain electrodes D1 and D2 is formed to reach the GaN layer, and each of the gate electrodes G1 and G2 is formed on the AlGaN layer. In a state where no voltage is applied to the gate electrodes G1 and G2, an electron depletion region occurs in the two-dimensional electron gas layer generated on the AlGaN/GaN heterogeneous interface immediately below the gate electrodes G1 and G2, and current does not flows. Meanwhile, when a voltage is applied to the gate electrodes G1 and G2, a current flows toward the drain electrode D2 from the drain electrode D1 (or reversely) in the AlGaN/GaN heterogeneous interface. To obtain a withstand voltage between the gate electrodes G1 and G2, a predetermined distance is required between the gate electrodes G1 and G2. However, no withstand voltage is required between the drain electrode D1 and the gate electrode G1, and between the drain electrode D2 and the gate electrode G2. For this reason, the drain electrode D1 and gate electrode G1, or the drain electrode D2 and gate electrode G2 may be overlapped with each other through an insulation layer In interposed therebetween. The element with such a configuration needs to be controlled based on the voltages of the drain electrodes D1 and D2, and driving signals are necessarily input to the respective gate electrodes G1 and G2 (hence, the element is referred to as a dual gate transistor structure).

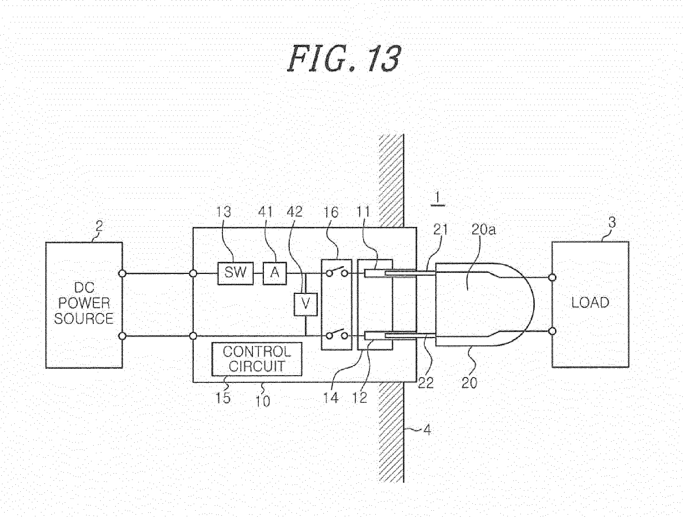

FIG. 13 shows another modification of the DC connection device 1 according to this embodiment. In this modification, the outlet 10 further includes a contact switching device 16 connected in series between the first connection terminals 11 and 12 and the semiconductor switch 13. The control circuit 15 turns on the semiconductor switch 13 after the electrical connection between the first connection terminals 11 and 12 and the second connection terminals 21 and 22 is completed and the contact switching device 16 is turned on. Also, the control circuit 15 turns off the contact switching device 16 after the semiconductor switch 13 is turned off while the relative position of the second connection terminal 21 or 22 to the first connection terminal 11 or 12 is reversely moved to change from a state where an electrical connection between the first connection terminal 11 or 12 and the second connection terminal 21 or 22 is completed to a state where an electrical disconnection between the first connection terminal 11 or 12 and the second connection terminal 21 or 22 is completed. For example, a relay, breaker, or the like may be used as the contact switching device 16. As such, in a state where the plug 20 is not connected to the outlet 10, contact points of the contact switching device 13 are opened, and the first connection terminals 11 and 12 of the outlet 10 are physically disconnected from the DC power source 2. For this reason, even though the semiconductor switch 13 is broken, it is possible to ensure safety. Further, although chattering occurs when the plug 20 is connected to or separated from the outlet 10, it is possible to prevent electric discharge from being generated between the first connection terminals 11 and 12 and the second connection terminals 21 and 22.

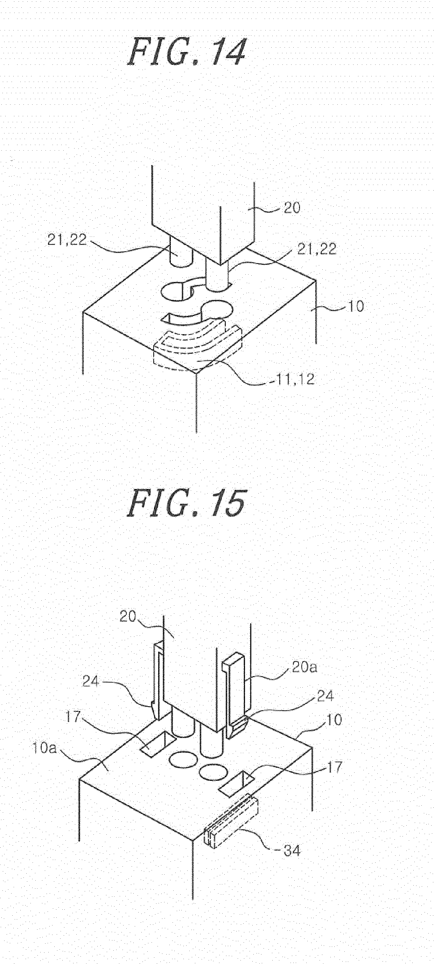

A method of connecting and disconnecting the plug 20 to and from the outlet 10, i.e., the movement of the second connection terminal 21 or 22 with respect to the first connection terminal 11 or 12 may be implemented not only through a linear motion such as a typical insertion and separation, but also through a rotary motion or a combination of the rotary motion and the linear motion, for example, as shown in FIG. 14. After the connection of the plug 20 to the outlet 10 is completed, i.e., after the second connection terminal 21 or 22 cannot relatively move any more with respect to the first connection terminal 11 or 12, the control circuit 15 turns on the contact switching device 16, and then, turns on the semiconductor switch 13. In a case where the outlet 10 does not have the contact switching device 16, the control circuit 15 turns on the semiconductor switch 13 after the second connection terminal 21 or 22 cannot relatively move any more with respect to the first connection terminal 11 or 12.

In addition, as shown in FIG. 15, there may be provided a mechanism for fixing the plug 20 to the outlet 10 after the plug 20 is connected to the outlet 10. For example, locking hooks 24 are respectively provided at both side portions of the main body 20a of the plug 20, and locking holes 17 are provided in the main body 10a of the outlet 10. A switch 34 is also provided near the locking hole 17 in the main body 10a of the outlet 10. If the plug 20 is connected to (inserted into) the outlet 10, the locking hooks 24 are deformed due to the elasticity of resin, thereby being fitted into the locking holes 17. Then, the locking hooks 24 are locked to the locking holes 17 by the elastically restoring force. Accordingly, the plug 20 is fixed to the outlet 10. Simultaneously, a front end portion of the locking hook 24 is brought into contact with the switch 34, and the switch 34 is turned on. After the switch 34 is turned on, the control circuit 15 turns on the contact switching device 16, and then, turns on the semiconductor switch 13. In order to remove the plug 20 from the outlet 10, a user presses both the locking hooks 24 toward the main body 20 to deform them. By doing so, the front end portion of the locking hook 24 is separated from the switch 34, and the switch 34 is turned off. If the switch 34 is turned off, the control circuit 15 immediately turns off the semiconductor switch 13, and then, also turns off the contact switching device 16. In this state, the user pulls out the plug 20 from the outlet 10. The fixing mechanism is not limited to that shown in this figure, but other structures may be applied. That is to say, the control circuit 15 may be configured to turn on/off the contact switching device 16 while the second connection terminals 21 and 22 are fixed to the first connection terminals 11 and 12 by the fixing mechanism.

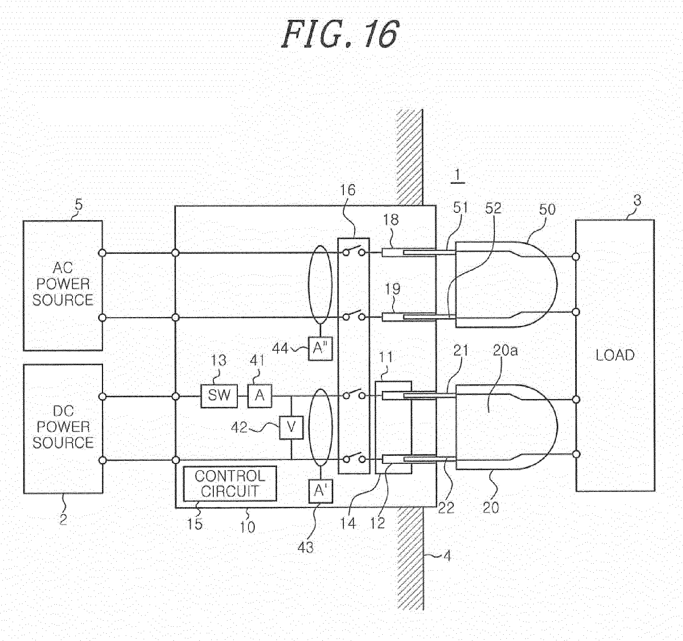

FIG. 16 shows still another modification of the DC connection device 1 according to this embodiment. In this modification, the outlet 10 is configured to have a hybrid type in which a single outlet 10 is equipped with DC power distribution and AC power distribution. With the wide use of a solar photovoltaic power generator or a household fuel cell, it is expected that an electric device such as an air conditioner or refrigerator driven directly using DC power will be developed. However, the solar photovoltaic power generation is likely to be influenced by weather or season, and the amount of power generated is unstable. In addition, the solar photovoltaic power generation cannot be performed after sunset.

For this reason, a secondary battery is generally used together with the solar photovoltaic power generator, and power charged in the secondary battery is used. However, the power charged in the secondary battery is not enough to cover the power demanded in all electronic appliances. The electric appliances with a large power consumption such as an air conditioner or refrigerator may be designed to have a hybrid type so as to use the conventional AC power source as a backup power. Thus, the outlet 10 shown in FIG. 16 is provided with a pair of third connection terminals 18 and 19 connected to the AC power source 5. Terminals 51 and 52 of an AC plug 50 are connected to the third connection terminals 18 and 19.Herein, a voltage as high as 100 V or 200 V is employed in the AC power source 5. However, unlike the DC power distribution system, even if an arc discharge occurs when the plug 50 is pulled out of the outlet 10, the AC power distribution system is easy to extinguish the arc. Hence, a semiconductor switch is not particularly provided.

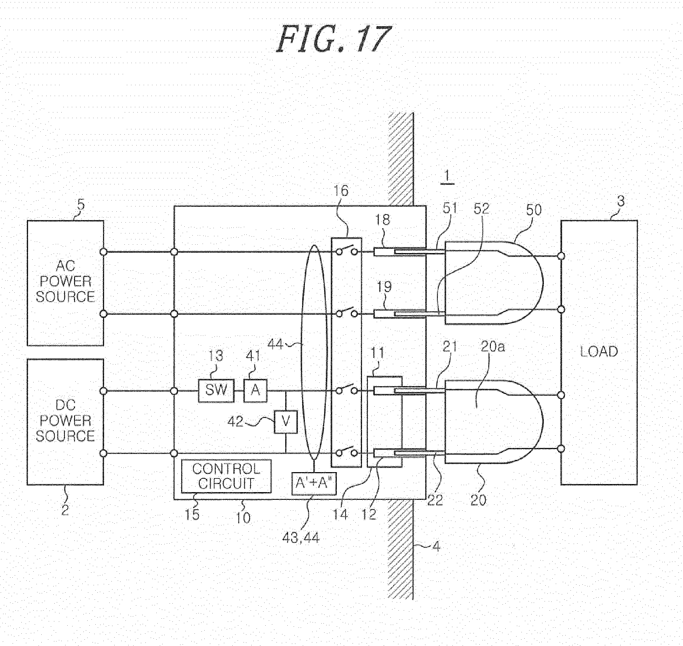

The contact switching device 16, for example, comprising a relay or a breaker is connected in series between the AC power source 5 and the pair of third connection terminals 18 and 19 (any one of them is possible) and functions as an AC circuit breaker. Alternatively, separately from the contact switching device 16, an AC circuit breaker may be connected between the AC power source 5 and the pair of third connection terminals 18 and 19. In addition, the outlet 10 is provided with a DC grounding current detection circuit (A') 43 for detecting grounding current flowing in the DC circuit between the DC power source 2 and the load 3; and an AC grounding current detection circuit (A") 44 for detecting grounding current flowing in the AC circuit between the AC power source 5 and the load 3. For example, a Hall element or the like may be used as the DC grounding current detection circuit 43. In addition, a zero current transformer (ZCT) or the like may be used as the AC grounding current detection circuit 44. Alternatively, as shown in FIG. 17, the DC circuit and the AC circuit may pass through a common core of a single zero current transformer, whereby the DC grounding current detection circuit 44 and the AC grounding current detection circuit 44 are partially made common. Accordingly, it is possible to realize the miniaturization and low cost of the outlet 10.

When any one of the DC grounding current detection circuit 43 and the AC grounding current detection circuit 44 detects the grounding current, the control circuit 15 turns off both the semiconductor switch 13 connected to the DC power source 2 and the contact switching device 16 (or AC circuit breaker) connected to the AC power source 5. In this case, it will be apparent that the off-timing of the semiconductor switch 13 is sifted to be earlier than the off-timing of the contact switching device 16 connected to the DC circuit.

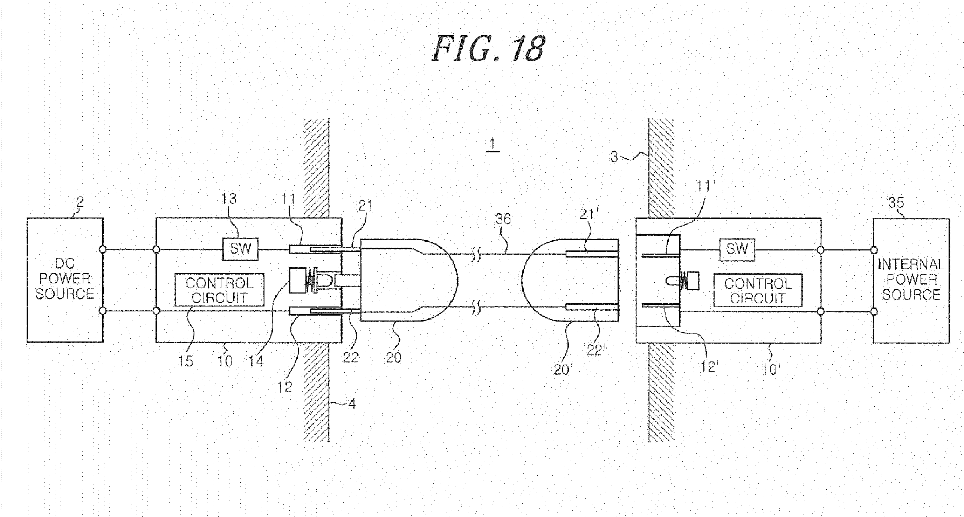

The present invention is not limited to the descriptions of the aforementioned embodiments, and various modifications and applications are possible. FIG. 18 shows an exemplary configuration in which an outlet 10' is also provided at the side of the load 3 and is connected to the outlet 10 of the side of the DC power source 2 through a cable 36. The outlet 10' at the side of the load 3 is connected to an internal power source (DC/DC converter or inverter) 35 of the load 3. The plugs 20 and 20' are respectively connected at both ends of the cable 36. In this case, the projection-depression of the second connection terminals 21 and 22 of the plug 20 is reverse to that of second connection terminals 21' and 22' of the plug 20'. Similarly, the projection-depression of the first connection terminals 11 and 12 of the outlet 10 is reverse to that of first connection terminals 11' and 12' of the outlet 10'. As such, the outlet 10 or 10' that is the first connector is not necessarily connected to the DC power source 2, and may be connected to the load 3 or the internal power source 35 of the load 3. Alternatively, the outlet 10 or 10' may be connected to a circuit breaker or the like of a power distributing board connected to the DC power source. The plug 20 or 20' that is the second connector is not necessarily connected directly to the load, and may be connected to the cable 36 through which the DC power source 2 and the load 3 are connected.

The aforementioned various embodiments can be implemented by appropriate combination thereof. For example, the optical sensor shown in FIG. 3 can be applied to the DC connection device shown in FIG. 16.

While the invention has been shown and described with respect to the embodiments, the present invention is not limited thereto. It will be understood by those skilled in the art that various changes and modifications may be made without departing from the scope of the invention as defined in the following claims.

## Claims

1. A DC connection device, comprising:
a first connector connected to a DC power source or a load; and
a second connector connected to the first connector,
wherein the first connector or the second connector has a semiconductor switch that is turned on when a portion of at least one of terminals of one of the first and second connectors is brought into contact with a terminal of the other of the first and second connectors, and is turned off before the terminal of the one of the first and second connectors is completely separated from the terminal of the other of the first and second connectors.

2. A DC connection device, comprising:
a first connector connected to a DC power source or a load, the first connector having a pair of first connection terminals; and
a second connector connected to the first connector, the second connector having a pair of second connection terminals to be electrically connected to the first connection terminals,
wherein the first connector comprises:
a semiconductor switch connected in series between the DC power source or the load and any one of the first connection terminals;
a connection-state detecting unit for detecting a relative positional relationship between the second connection terminal and the first connection terminal; and
a control circuit for turning on or off the semiconductor switch according to a result detected by the connection-state detecting unit,
wherein the connection-state detecting unit detects a change in the relative position of the second connection terminal to the first connection terminal, and
wherein the control circuit turns on and off the semiconductor switch when the relative position of the second connection terminal to the first connection terminal ensures that the first connection terminal and the second connection terminal are electrically connected.

3. The DC connection device of claim 2, wherein the first connection terminal and the second connection terminal are securely electrically connected at a position where the first connection terminal cannot relatively move any more with respect to the second connection terminal, or in the vicinity just before the position.

4. The DC connection device of claim 3, wherein the control circuit turns off the semiconductor switch while the relative position of the first connection terminal to the second connection terminal is reversely moved to change from a state where an electrical connection between the first connection terminal and the second connection terminal is completed to a state where an electrical disconnection between the first connection terminal and the second connection terminal is completed.

5. The DC connection device of any one of claims 2 to 4, wherein the connection-state detecting unit is provided at the position in which the first connection terminal cannot relatively move any more with respect to the second connection terminal or in the vicinity just before the position, and the connection-state detecting unit includes a mechanical switch to be brought into contact with the second contacting terminal.

6. The DC connection device of any one of claims 2 to 4, wherein the connection-state detecting unit is provided at the position in which the first connection terminal cannot relatively move any more with respect to the second connection terminal or in the vicinity just before the position, and the connection-state detecting unit includes an optical sensor having a light emitting element and a light receiving element for detecting the existence of the first connection terminal.

7. The DC connection device of any one of claims 2 to 4, wherein the connection-state detecting unit includes a sensor or a switch provided in a main body of the first connector to detect that a main body of the second connector comes into contact with the main body of the first connector.

8. The DC connection device of any one of claims 2 to 7, wherein the first connector has a current detection circuit for detecting a current flowing through the load, and
wherein the control circuit turns off the semiconductor switch when a current value detected by the current detection circuit exceeds a predetermined current threshold value and turns on the semiconductor switch when the current value becomes less than or equal to the current threshold value.

9. The DC connection device of any one of claims 2 to 8, wherein the first connector has a voltage detection circuit for detecting a voltage applied to the load, and
wherein the control circuit turns off the semiconductor switch when a voltage value detected by the voltage detection circuit exceeds a predetermined voltage threshold value and turns on the semiconductor switch when the voltage value becomes less than or equal to the voltage threshold value.

10. The DC connection device of any one of claims 2 to 7, wherein the first connector comprises a current detection circuit for detecting a current flowing through the load and a voltage detection circuit for detecting a voltage applied to the load,
wherein the semiconductor switch comprises two FETs connected in series so that sources and drains of the two FETs are opposed to each other, and
wherein the control circuit turns off one of the two. FETs when a current value detected by the current detection circuit exceeds a predetermined current threshold value, and turns on the one of the two FETs when the current value becomes less than or equal to the current threshold value; and the control circuit turns off the other of the two FETs when a voltage value detected by the voltage detection circuit exceeds a predetermined voltage threshold value, and turns on the other of the two FETs when the voltage value becomes less than or equal to the voltage threshold value.

11. The DC connection device of any one of claims 2 to 7, wherein the first connector comprises a current detection circuit for detecting a current flowing through the load and a voltage detection circuit for detecting a voltage applied to the load,
wherein the semiconductor switch comprises a bidirectional switching element having a lateral transistor structure using a GaN/AlGaN structure, and
wherein the control circuit turns off the bidirectional switching element when a current value detected by the current detection device exceeds a predetermined current threshold value or when a voltage value detected by the voltage detection circuit exceeds a predetermined voltage threshold value; and the control circuit turns on the bidirectional switching element when the current value becomes less than or equal to the current threshold value or when the voltage value becomes less than or equal to the voltage threshold value.

12. The DC connection device of any one of claims 8, 10 and 11, wherein the control circuit comprises a timer, and
wherein the control circuit detects, by using the timer, a time duration during which the current value detected by the current detection circuit exceeds the current threshold value and turns off the semiconductor switch when the time duration exceeds a predetermined time threshold value.

13. The DC connection device of any one of claims 2 to 12, wherein the first connector further comprises a contact switching device connected in series between the first connection terminals and the semiconductor switch.

14. The DC connection device of claim 13, wherein the control circuit turns on the semiconductor switch after the electrical connection between the first connection terminal and the second connection terminal is completed and the contact switching device is turned on.

15. The DC connection device of claim 14, wherein the control circuit turns off the contact switching device after the semiconductor switch is turned off while the relative position of the first connection terminal to the second connection terminal is reversely moved to change from the state where the electrical connection between the first connection terminal and the second connection terminal is completed to the state where the electrical disconnection between the first connection terminal and the second connection terminal is completed.

16. The DC connection device of any one of claims 13 to 15, wherein the movement of the first connection terminal with respect to the second connection terminal includes any one of a linear motion and a rotary motion or both the linear motion and the rotary motions, and
wherein the control circuit turns on the contact switching device after the first connection terminal cannot relatively move any more with respect to the second connection terminal.

17. The DC connection device of any one of claims 13 to 16, wherein the first connector further comprises a fixing mechanism for fixing the state where the first connection terminal cannot relatively move any more with respect to the second connection terminal, and
wherein the control circuit turns on and off the contact switching device while the second connection terminal is fixed to the first connection terminal by the fixing mechanism.

18. The DC connection device of any one of claims 2 to 17, wherein the first connector further comprises a pair of third connection terminals connected to an AC power source or the load.

19. The DC connection device of claim 18, wherein the first connector further comprises an AC circuit breaker connected in series between the AC power source and any one of the third connection terminals, an AC grounding current detection circuit for detecting a grounding current flowing in an AC circuit between the AC power source and the load or another load, and a DC grounding current detection circuit for detecting a grounding current flowing in a DC circuit between the DC power source and the load, and
wherein the control circuit turns off both the semiconductor switch connected to the DC power source and the AC circuit breaker connected to the AC power source when the grounding current is detected by any one of the DC grounding current detection circuit and the AC grounding current detection circuit.

20. The DC connection device of claim 19, wherein the DC grounding current detection circuit and the AC grounding current detection circuit are at least partially common.
